(19) Europäisches Patentamt

European Patent Office

Office européen des brevets

(11) **EP 1 722 273 A2**

(12) **EUROPEAN PATENT APPLICATION**

(43) Date of publication:
**15.11.2006 Bulletin 2006/46**

(51) Int Cl.:
***G03F 7/20*** (2006.01)

(21) Application number: **06009684.9**

(22) Date of filing: **10.05.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **12.05.2005 JP 2005140369**

(71) Applicant: **SHARP KABUSHIKI KAISHA**
**Osaka-shi, Osaka 545-8522 (JP)**

(72) Inventors:
• **Sakai, Keiji**
**Nara-shi**
**Nara 631-0013 (JP)**

• **Kokubo, Fumio**
**Shiki-gun**
**Nara 636-0247 (JP)**
• **Kimura, Takashi**
**Tenri-shi**
**Nara 632-0004 (JP)**
• **Abe, Ryou**
**Tenri-shi**
**Nara 632-0004 (JP)**

(74) Representative: **Müller - Hoffmann & Partner**
**Patentanwälte,**
**Innere Wiener Strasse 17**
**81667 München (DE)**

(54) **Exposure method and exposure device**

(57) An irradiation position of a beam array made up of m rows and n columns of beams is moved along the columns of the beam array with respect to an exposure target, while pulse irradiation of the beam array is carried out. The moving distance f of the irradiation position during an interval between two pulse irradiations is not shorter than the diameter $\alpha$ of each beam and shorter than the length H of the beam array along the columns. This arrangement makes it possible to increase the speed of exposure. Also, an exposure method and exposure device which excel in efficiency of the use of beams are provided.

FIG. 1 (a)

EP 1 722 273 A2

**(Cont. next page)**

# FIG. 1 (b)

moving direction

**Description**

FIELD OF THE INVENTION

The present invention relates to an exposure method preferably used for transferring an exposure pattern onto a photosensitive material in a semiconductor manufacture process and a printed board manufacture process, and also relates to an exposure device.

BACKGROUND OF THE INVENTION

In an exposure technique used in a semiconductor manufacture process and a printed board manufacture process, a method in which a mask having an exposure pattern is made in advance and the exposure pattern is transferred to a substrate has given way to a maskless method that does not require a mask.

Various types of maskless exposure devices have been proposed. A typical one among such devices is arranged in such a manner that exposure by a light beam modulated in accordance with image data is carried out using a spatial light modulator (SLM).

Patent Documents 1 (Japanese Laid-Open Patent Application No. 10-209019; published on August 7, 1998) and 2 (Japanese Laid-Open Patent Application No. 2004-12899; published on January 15, 2004) disclose exposure devices each of which uses a digital micro mirror device (DMD) as an SLM.

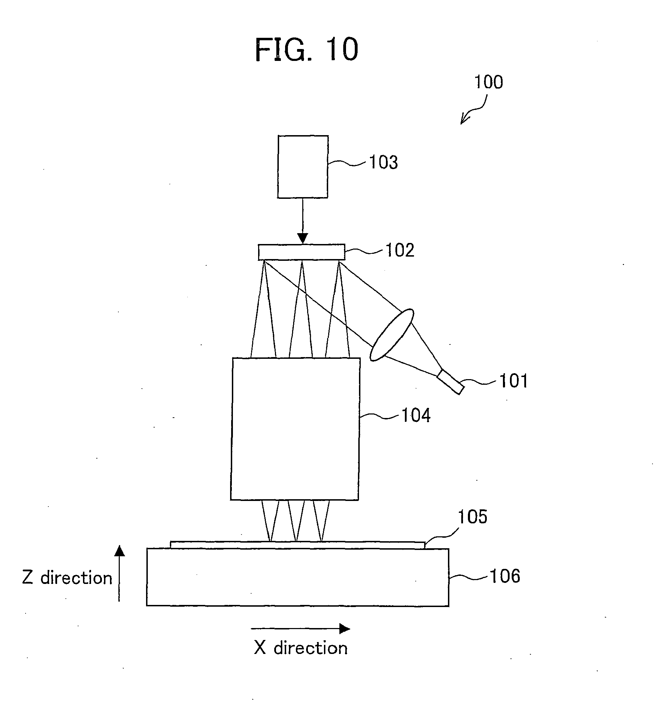

The following will describe such a conventional exposure device in reference to Fig. 10. Fig. 10 is a front view showing the substantial part of the conventional exposure device.

As shown in Fig. 10, a conventional exposure device 100 includes: a stage 106 supporting a substrate 105; a DMD 102 (SLM) that opposes to the surface, of the stage 106, on which the substrate 105 is provided; an optical condensing system 104 provided between the substrate 105 and the DMD 102; and a light source 101 that emits a light beam which is led to the DMD 102. The DMD 102 is connected to a controller 103.

While supporting the substrate 105 on which a photosensitive material is applied, the stage 106 can move in the X direction (in parallel to the surface of the substrate 105), Y direction (perpendicular to the X direction and in parallel to the surface of the substrate 105), and Z direction (perpendicular to both the X and Y directions) indicated in Fig. 10.

The controller 103 includes: a data processing section (not illustrated) which processes exposure data; and an element drive control section (not illustrated) that drives micro mirrors of the DMD 102 in accordance with the exposure data having been processed by the data processing section.

The DMD 102 generates reflected light and apply the reflected light onto the substrate 105. The reflected light is generated by dividing and modulating a light beam, which is emitted from the light source 101, into a plurality of array beams, under the control of the element drive control section.

The optical condensing system 104 is an optical unit that concentrates, at the surface of the substrate 105, the reflected light coming from the DMD 102.

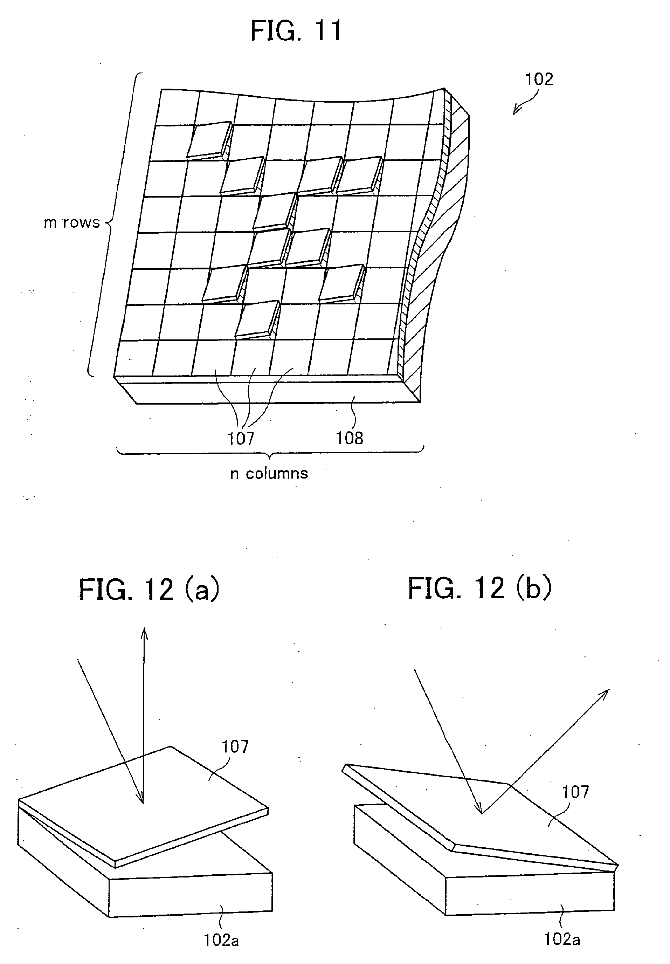

The following discusses how the DMD 102 is arranged and in what manner the DMD 102 operates, in reference to Figs. 11 and 12. Fig. 11 is an oblique perspective view illustrating a conventional DMD. Figs. 12(a) and 12(b) are oblique perspective views illustrating in what manner a micro mirror of the conventional DMD operate. Fig. 12(a) shows an on-state micro mirror, while Fig. 12(b) shows an off-state micro mirror.

As shown in Fig. 11, the DMD 102 is arranged in such a manner that micro mirrors 107 are provided on a substrate 108, in a matrix manner (m rows and n columns). Each micro mirror 107 is switched between the on-state and off-state. The micro mirror 107 tilts in the range of $\pm\alpha$ degrees (e.g. $\pm10°$) with respect to the substrate of the SLM 102, around the diagonal line of the surface of the mirror.

More specifically, a micro mirror 107 changed to the on-state by the control signal tilts, as shown in Fig. 12(a), at $+\alpha$ degrees with respect to the substrate 108 of the SLM 102. On the other hand, a micro mirror changed to the off-state by the control signal tilts, as shown in Fig. 12(b), at $-\alpha$ degrees with respect to the substrate 108 of the SLM 102. The exposure device 100 is provided with a light-absorbing body (not illustrated) on the light path of the light beam reflected on a micro mirror in the off-state. In other words, light reflected on a micro mirror in the off-state is absorbed by the light-absorbing body, and hence only light reflected on a micro mirror in the on-state irradiates the substrate 105.

In this manner, a pattern corresponding to exposure data processed by the data processing section is transferred onto the photosensitive material on the substrate 105 without using a mask, by controlling, in accordance with the exposure data, the tilt of each micro mirror 107 of the SLM 102.

According to Patent Documents 1 and 2, an exposure method using the exposure device 100 as above is arranged such that an exposure position (irradiation position) on the substrate 105 is changed by moving the stage 106 in parallel with the substrate 105 (i.e. in the X and Y directions).

According to the method disclosed in Patent Document 1, in particular, the stage 106 is stopped so that a particular area of the substrate 105 is subjected to exposure, and then exposure is performed again after changing the exposure position by moving the stage 106 while the exposure is not carried out. According to Patent Document 1, such exposure is carried out more than once, and as a result a panel pattern (exposure image) is formed by combining a plurality of patterns.

According to the method above, it takes about one second to position and stop the stage 106. On this account, the stage 106 must be positioned and stopped for tens of thousands of times to subject a large substrate (for a liquid crystal panel, for example) to exposure. The above-described method is therefore not suitable for the speed up.

In the meanwhile, Patent Document 2 discloses an exposure device that carries out scanning and exposure of a photosensitive material on a stage 106 which is on the move. That is, according to the exposure method disclosed by Patent Document 2, the stage 106 is moved while light is applied thereto. It is therefore possible to drastically shorten the time required for stopping the stage, because the process to move and stop the stage each time an exposure position is changed is unnecessary. This method in which exposure is continuously carried out is termed "continuous exposure method" in this specification.

However, even if the continuous exposure method is used, the speed (exposure speed) of exposure image formation is not sufficiently high.

Details of the continuous exposure method disclosed by Patent Document 2 will be given in reference to Figs. 8(a) and 8(b). According to this method, as described below, the stage moving speed does not reach the limit even if the driving speed of the DMD is maximized, to increase the resolution in the main scanning direction so as to reach the required level as an exposure device. In short, the stage does not fulfill its potential in terms of the speed.

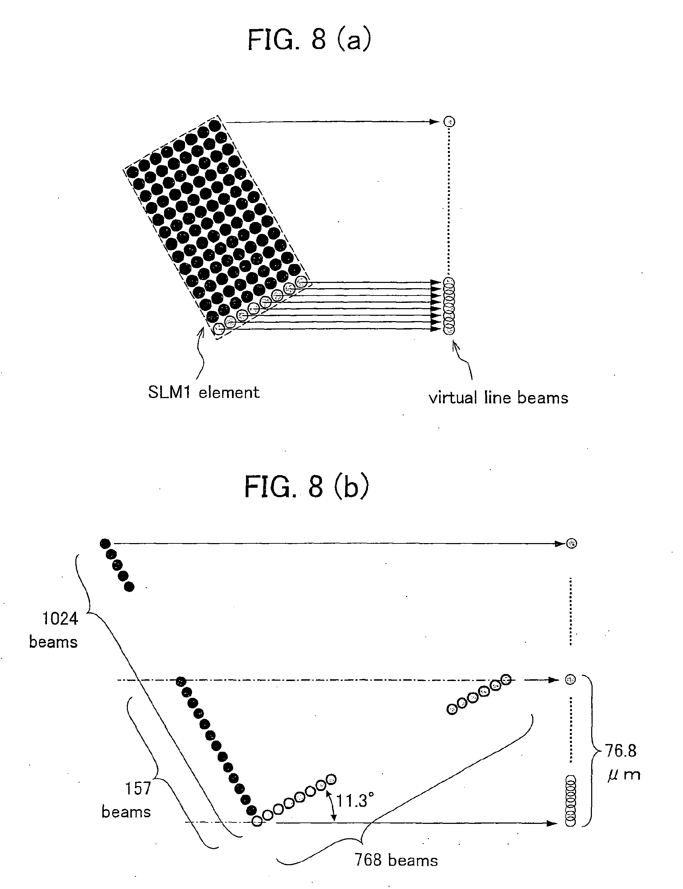

Figs. 8(a) and 8(b) relate to a conventional continuous exposure method. Fig. 8(a) shows virtual line beams formed by a beam array. Fig. 8(b) indicates the efficiency of the use of pixels.

As Fig. 8(a) shows, exposure by the continuous exposure method is carried out in such a manner that a beam array with m rows and n columns is tilted at 1/m toward the scanning direction so that a line beam array virtually perpendicular to the scanning direction is formed. With the continuous exposure, as shown in the figure, beams are aligned without gaps. However, according to the method, neighboring beams exceedingly overlap with each other. It is therefore impossible to effectively utilize the beams.

In other words, the continuous exposure method is multiple exposure in which beams overlap with each other. To put it differently, the efficiency of the use of pixels of the SLM made up of a plurality of micro mirrors is extremely low, and hence it is impossible to realize high-speed exposure. In reference to Fig. 8(b), the following will specifically describe the correlation between the scanning speed and the efficiency of use.

In Fig. 8(b), the size of one pixel (micro mirror) of the DMD is 15μm each side, the number of pixels is 768 rows × 1024 columns, the reduction ratio of the exposure optical system is 1/30, and the resolution of a pattern to be exposed is 0.1μm. In this case, the total number of beams irradiating the substrate is about 0.8 million, and the size of each beam is 0.5μm. As shown in Fig. 8(b), in a case where beams sized 0.5μm each are aligned at intervals of 0.1μm, the beam array is tilted at about 11.3° toward the scanning direction. Therefore, the line length formed by the beams of one horizontal row (768 beams) is as below.

$$0.1 \times 768 = 76.8 \mu m$$

This length is converted to the number of beams of one vertical column as follows.

$$76.8 / \cos 11.3° / 0.5 = 157 \text{ beams}$$

In this way, the beams (768 beams) of one row overlap the remaining (157-1) rows × 768 beams. The efficiency of the use of the pixels is therefore worked out as below.

$$768 / (157 \times 768) = 0.006$$

In this way, the efficiency of the use is less than 1%.

To increase the exposure speed of the continuous exposure method, the stage moving speed in the main scanning direction is increased. However, even if the switching speed of the DMD is set at the maximum (15μs), the maximum stage moving speed is 0.5μm/15μs=33mm/s, to perform the drawing with the resolution of 0.5μm. The stage has potential to move at a speed which is about ten times higher than the maximum speed, i.e. about 300mm/s. That is to say, even if the stage can move at a higher speed, the switching speed of the DMD is the bottle neck. On this account, the stage moving speed is not sufficiently high and hence the processing speed (exposure speed) is very low.

Since it is difficult in the current technical level to cause the drive time of the DMD to be shorter than about 15μsec, the stage moving speed cannot be increased in the continuous exposure method. That is, to achieve high-speed exposure, it is necessary to use a different exposure method which maximally allows for the improvements in (i) the efficiency of the use of pixels, (ii) the stage moving speed, and (iii) the switching speed of the SLM.

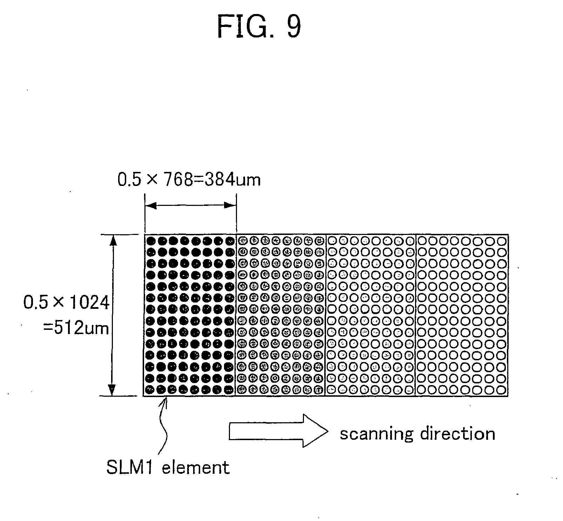

Now, referring to Fig. 9, the following will describe another conventional arrangement in which the efficiency of the use of pixels is higher than that of the continuous exposure method, and the stage can fulfill its potential in terms of the speed.

Fig. 9 shows a stamp method which is one of the conventional exposure methods. The stamp method does not use a beam array as virtual line beams. According to the stamp method, a rectangular irradiation beam array is not tilted, and scanning is carried out in parallel to the shorter sides (row direction) of the rectangular so that exposure is carried out like stamping. According to the stamp method, the stage does not stop while exposure is carried out.

The stamp method is different from the continuous exposure method in which the SLM is continuously irradiated with laser beams and the SLM switches the respective beams. In the stamp method, the SLM is irradiated with a pulsed light beam when a beam array is positioned at a place where stamping has to be performed, while each beam is switched by the SLM. As a result, an exposure pattern is formed by pulse exposure.

Now, assume that, as in the case of the continuous exposure shown in Figs. 8(a) and 8(b), the DMD is arranged such that the size of one pixel (mirror) of the DMD is 15μm, the number of pixels is 1024×768, and the reduction ratio of the exposure optical system is 1/30.

As shown in Fig. 9, according to the stamp method, pulse exposure is carried out each time the length of the shorter sides (row direction, main scanning direction) of the beam array is scanned.

The length is expressed as: 768×0.5=384μm.

According to this method, as Fig. 9 clearly shows, the neighboring pixels do not overlap with each other at all. The efficiency of the use of pixels is therefore 100%. That is, since the efficiency of the use of pixels is at least 160 times higher than the continuous exposure method (i.e. 1/0.006), the speed is therefore 160 times higher than the case of the continuous exposure method.

To perform the pulse exposure, the DMD must be switched to the next pattern while the pulse exposure is carried out. However, according to the stamp method, the distance at which the stage must move between the current pulse exposure and the next pulse exposure (i.e. during pulse exposure interval) is long. On this account, the speed of the DMD is not at the maximum even if the speed of the stage is maximized. In short, the DMD cannot fulfill its potential in terms of the speed.

To give an actual example, the relationship between the stage moving speed and the drive speed of the DMD in the stamp method of Fig. 9 is examined. Provided that the stamp method is adopted and the stage moving speed is at 300mm/sec which is the currently maximum speed, a time (pulse interval time) between the current pulse exposure and the next pulse exposure is as follows.

$$384 \times 10^{-3}/300 = 1.28\mathrm{ms}$$

That is, the mirrors of the DMD are driven and the switch to the next exposure pattern is carried out, during this 1.28ms. In short, the response speed of the DMD is required to be not longer than 1.28ms. This speed is much lower than the potential (drive time: 15μs) of the currently-used DMD.

In this manner, the stamp method can maximally extract the stage moving speed but cannot fully extract the potential drive speed of the DMD. Therefore, the improvement in regard of the drive speed of the DMD would inevitably result in further speed up for at least several tens of times.

SUMMARY OF THE INVENTION

In consideration of the problem above, the objective of the present invention is to provide an exposure method and exposure device, which can increase the speed of exposure and improve the efficiency in the use of light beams.

To achieve the objective above, an exposure method, in which a beam array made up of m rows and n columns of beams is applied, by pulse irradiation, to an exposure target twice or more, includes the step of (i) moving an irradiation position of the beam array at a constant speed, in a direction along the columns with respect to the exposure target, the step (i) including the sub-step of (I) performing the pulse irradiation, the irradiation position moving at a distance not shorter than a diameter of each of the beams and shorter than a length of the beam array along the columns, during an interval between one pulse irradiation and a directly subsequent pulse irradiation.

According to the arrangement above, being different from the aforesaid continuous exposure method, an exposure target is subjected to exposure by means of pulse irradiation. On this account, a certain level of resolution is maintained even if the moving speed of an irradiation position is increased. Furthermore, the efficiency in the use of beams is improved.

According to the arrangement above, the distance at which the irradiation position moves during an interval between one pulse irradiation and a directly subsequent pulse irradiation is shorter than the length of the beam array along the columns. On this account, the interval between pulse irradiations is shortened as compared to the stamp method. It is therefore possible to exploit the potential of the light irradiation side. As a result, the speed (exposure speed) of formation of an exposure image is increased as compared to the stamp method.

In the beam array, a pitch of the beams is preferably longer than the diameter of each of the beams.

According to this arrangement, an unnecessary overlap between neighboring beams is reduced, and hence the efficiency in the use of the beams is further improved.

The exposure method is preferably arranged such that, in the sub-step (I) the beam array is applied the exposure target using a SLM, and provided that the speed of movement of the irradiation position with respect to the exposure target is v, a drive time of the SLM is t, the pitch of the beams of the beam array is h, and the diameter of each of the beams is $a$, $h^2/a/v > t$ is satisfied.

With this arrangement, the surface of the exposure target is exposed to light without omission.

The exposure method is preferably arranged such that, in the sub-step (I), provided that how many times multiple exposure is carried out is k, the number of the beams of the beam array along the columns is n, and the diameter of each of the beam is $a$, $n=(h/a)^2 \times k$ is satisfied.

According to this arrangement, an unnecessary overlap between neighboring beams is reduced, and hence the efficiency in the use of the beams is further improved.

The exposure method is preferably arranged such that, provided that the diameter of each of the beams is $a$ and the pitch of the beams is h, the rows of the beam array are tilted at $\sin^{-1}(a/h)$ toward a direction of movement of the irradiation position.

According to this arrangement, an unnecessary overlap between neighboring beams is reduced, and hence the efficiency in the use of the beams is further improved.

The exposure method is preferably arranged such that, during a pulse irradiation time, the irradiation position moves at a distance not longer than exposure precision.

This arrangement makes it possible to improve the exposure precision.

To achieve the objective above, an exposure device, which applies, by pulse irradiation, a beam array made up of m rows and n columns of beams to an exposure target twice or more, includes: irradiation position moving means for moving an irradiation position of the beam array at a constant speed, in a direction along the columns with respect to the exposure target, and light irradiation means for carrying out the pulse irradiation while the irradiation position moving means is in operation, during an interval between one pulse irradiation and a directly subsequent pulse irradiation, the irradiation position moving means moving the irradiation position at a distance not shorter than a diameter of each of the beams and shorter than a length of the beam array along the columns.

According to the arrangement above, the exposure speed is increases as compared to an exposure device which adopts the conventional continuous exposure method or the stamp method.

The exposure device is preferably arranged such that, the light irradiation means includes a light source and a SLM that forms the beam array by reflecting, using one or more mirror, pulsed light emitted from the light source, and each of said one or more mirror is individually driven so that at least one of diffraction-reflected light and regular-reflected light is generated from the pulsed light.

According to the arrangement above, each mirror of the SLM generates at least one of the diffraction-reflected light and regular-reflected light. On this account, an exposure pattern is switchable as each mirror is switched between the diffraction-reflected light and regular-reflected light. This makes it possible to form various types of exposure patterns.

The exposure device is preferably arranged such that, a shielding member that allows the diffraction-reflected light from the SLM to pass through while shields the regular-reflected light is provided between the SLM and the exposure target.

According to this arrangement, the shielding member separates the diffraction-reflected light from the regular-reflected light, and causes the exposure target to be irradiated only with the diffraction-reflected light. This makes it possible to form an exposure pattern by means of the diffraction-reflected light.

The exposure device is preferably arranged such that, said one or more mirror has a reflecting surface and generates the diffraction-reflected light by deforming a part of the reflecting surface.

According to this arrangement, a part of the reflecting surface is deformed so that a phase difference is partially generated. As a result diffraction-reflected light is generated. In this manner, diffraction-reflected light is generated with a simple arrangement.

The exposure device is preferably arranged such that, said one or more mirror is arranged so that to what extent said part of the reflecting surface is deformed is adjustable.

According to this arrangement, multistage adjustment of an amount of diffraction-reflected light is realized by adjusting to what extent the reflecting surface is deformed. Therefore, gray-scale exposure is realized by adjusting an amount of diffraction-reflected light, and hence a high-definition exposure image can be formed.

The exposure device is preferably arranged such that, the light source includes a solid laser.

According to this arrangement, it is possible to emit light with a short pulse width and a frequency suitable for an exposure device of the present invention. A highly-precise exposure image is therefore formed.

Additional objects, features, and strengths of the present invention will be made clear by the description below. Further, the advantages of the present invention will be evident from the following explanation in reference to the drawings.

## BRIEF DESCRIPTION OF THE DRAWINGS

Figs. 1(a) and 1(b) are plan views showing a beam array irradiating an exposure target, according to an exposure method of an embodiment. Fig. 1(a) shows a beam array which is emitted in one pulse irradiation. Fig. 1(b) shows an exposure state after the pulse irradiation is carried out more than once.

Fig. 2 is a magnified image of the beam array of the exposure method of the embodiment.

Fig. 3 indicates timings to emit pulsed light in the embodiment.

Fig. 4 is a front view of the substantial part of the exposure device of the embodiment.

Fig. 5 is a plan view showing micro mirrors of a SLM of the embodiment.

Figs. 6(a)-6(c) are cross sections of the micro mirror shown in Fig. 5, taken at the P-P' line. Fig. 6(a) shows the micro mirror in the off-state. Figs. 6(b) and 6(c) show the micro mirror in the on-state.

Fig. 7 is a front view of a reduced projection exposure optical system and its peripheral members of the exposure device of the embodiment.

Figs. 8(a) and 8(b) show a conventional continuous exposure method. Fig. 8(a) shows virtual line beams formed by a beam array. Fig. 8(b) indicates the efficiency of the use of pixels.

Fig. 9 shows a stamp method which is one of conventional exposure methods.

Fig. 10 is a front view showing the substantial part of the conventional exposure device.

Fig. 11 is an oblique perspective view showing a conventional DMD.

Figs. 12(a) and 12(b) are oblique perspective views showing the operation of micro mirror of the conventional DMD. Fig. 12(a) shows the micro mirror in the on-state. Fig. 12(b) shows the micro mirror in the off-state.

## DESCRIPTION OF THE EMBODIMENTS

[Exposure Device]

An exposure device of the present invention causes, by pulse irradiation, an exposure target to be irradiated with a beam array made up of m rows and n columns of beams. The exposure device includes: irradiation position moving means that moves, at a predetermined speed, an irradiation position of the beam array, in parallel to the rows of the beam array with respect to the exposure target; and light irradiation means that carries out the pulse irradiation while the irradiation position moving means is in operation. To what extent the irradiation position moving means moves the irradiation position during the pulse irradiation is determined so as to be longer than the beam diameter of each beam and not to be longer than the length of the beam array in the column direction.

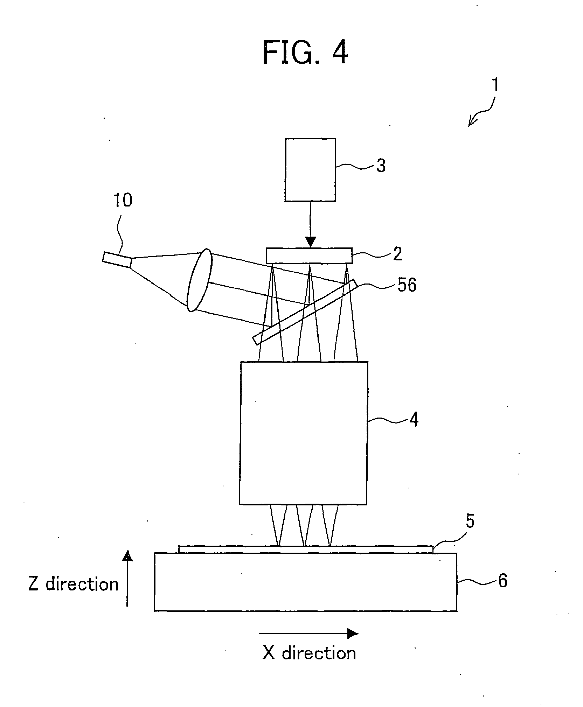

As an example of such an exposure device, the following will describe an exposure device of the present embodiment in reference to Figs. 4-7.

Fig. 4 is a front view showing the substantial part of the exposure device of the present embodiment.

As shown in Fig. 4, the exposure device 1 of the present embodiment subjects a substrate 5 (exposure target) to pulse irradiation of a beam array emitted from beam irradiation means (light source 10, SLM 2).

The exposure device 1 includes: a stage 6 (irradiation position moving means) supporting the substrate 5; a SLM 2 facing the surface, of the stage 6, on which the substrate 5 is provided; an optical condensing system 4 provided between the substrate 5 and the SLM 2; and a light source 10 emitting a light beam which is led to the SLM 2. The SLM 2 is connected with a controller 3. As described below, a polarizing beam splitter 56 is provided on the path (light path) of light emitted from the light source 10.

The substrate 5 is coated with a photosensitive material. The substrate 5 is provided on the stage 6 so that the surface coated with the photosensitive material, i.e. the photosensitive surface of the substrate 5 faces the optical condensing system 4. In the present embodiment, the substrate is a glass plate typically used for flat panel displays.

While supporting the substrate 5, the stage 6 can move in the X direction (in parallel to the photosensitive surface of the substrate 5, an irradiation position moving direction), the Y direction (perpendicular to the X direction and in parallel to the photosensitive surface of the substrate 5), and the Z direction (perpendicular to both the X and Y directions) in the figure.

The light source 10 emits a light beam (light) to the SLM 2. Examples of the light beam include: two bright lines (e.g. light beams with wavelengths of 436$\mu$m and 365$\mu$m, respectively) of a mercury lamp; Nd-YAG with an wavelength of 355nm; XeCl with an wavelength of 308nm; KrF with an wavelength of 248nm; and an excimer laser with an wavelength of 193nm. The light source of the present embodiment performs pulse emission of a light beam to the SLM 2. Therefore, the substrate 5 is subjected to pulse irradiation of a beam array. The pulse irradiation will be described later.

The controller 3 includes a data processing section that processes exposure data and an element drive control section that drives the SLM 2 in accordance with the exposure data processed by the data processing section. More specifically, the element drive control section can, as described below, switch between exposure patterns formed on the substrate 5, by driving the micro mirrors 21 of the SLM 2.

The optical condensing system 4 is an optical unit that concentrates, on the substrate 5, light reflected on the micro mirrors 21 of the SLM 2. As described below, the optical unit of the present embodiment may be provided with a reduced projection exposure optical system 50 having a shielding member 53, as described below. The reduced projection exposure optical system 50 will be described later.

The SLM 2 of the present embodiment is provided with m rows and n columns of micro mirrors. The micro mirrors reflect light emitted from the light source 10, so that the light is divided and modulated into a beam array. The substrate 5 is irradiated with this beam array.

The SLM 2 may be a conventional one. For example, the aforesaid DMD or the like may be adopted as the SLM 2 (see Figs. 11 and 12).

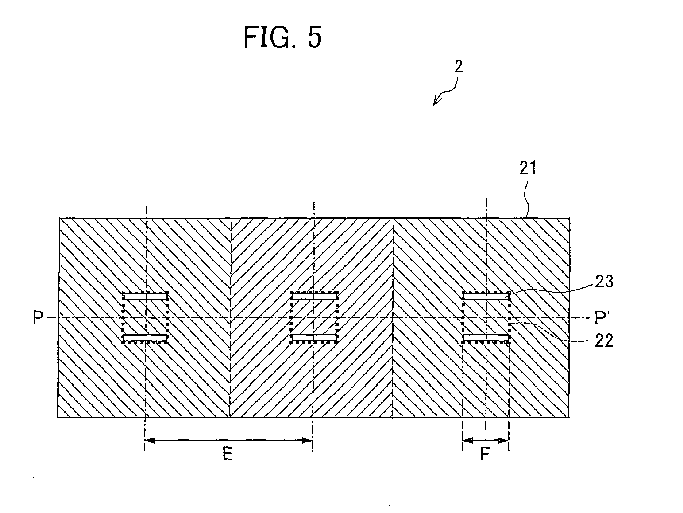

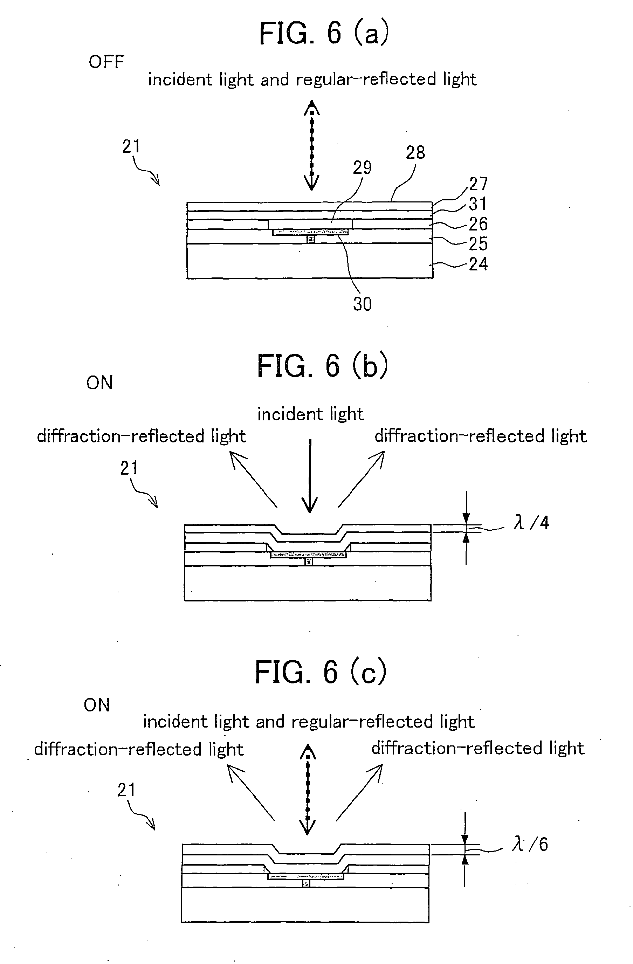

The conventional DMD shown in Fig. 11 is, as described above, simply arranged such that micro mirrors are densely aligned. In such a DMD, each micro mirror is small and hence the beam diameter is equal to the interval between beams. The beam array generated by the SLM of the exposure device of the present invention is, as described below (in [Exposure Method]), preferably arranged such that the interval between beams is longer than the beam diameter. To generate such a beam array, the SLM 2 is preferably arranged, for example, as shown in Figs. 5 and 6.

Fig. 5 is a plan view showing the micro mirrors 21 of the SLM 2 of the present embodiment. Figs. 6(a)-6(c) are cross sections of the micro mirror shown in Fig. 5, taken at the P-P' line. Fig. 6(a) shows the micro mirror 21 in the off-state, while Figs. 6(b) and 6(c) shows the micro mirror 21 in the on-state. In Figs. 6(a)-6(c), the traveling direction of incident light is indicated by a heavy-solid-lined arrow, the traveling direction of regular-reflected light is indicated by a dotted-line arrow, and the traveling direction of diffraction-reflected light is indicated by a thin-solid-line arrow.

The SLM 2 of the present embodiment is provided with micro mirrors 21 on a base 24. The micro mirrors 21 are provided in a matrix manner with m rows and n columns. The SLM 2 can form various types of exposure patterns by driving the micro mirrors 21.

As shown in Fig. 5, the surface (reflecting surface) of each micro mirror 21 has a deforming section 22 (indicated by dotted lines in Fig. 5). The deforming section 22 is square-shaped in the present embodiment, but the shape of the deforming section 22 is not particularly limited. Along opposing two sides of the deforming section 22, slits 23 are formed. Thanks to the slits 23, the deforming section 22 deforms independently of the surrounding mirror section.

As Figs. 6(a)-6(c) show, each of the micro mirrors 21 is arranged such that, on the base 24, an insulating layer 25, a spacer 26, an upper insulating layer 31, and an upper electrode 27 are deposited in this order. The surface of the electrode 27 functions as a reflecting surface 28 that reflects light emitted from the light source 10. In the cross section of the micro mirror 21, a lower electrode 30 is fitted in the insulating layer 25, at the lower part (on the base 24 side) of the deforming section 22. On the other hand, the spacer 26 is not formed above the lower electrode 30 (i.e. on the reflecting surface 28 side). That is, on account of the spacer 26, a space 29 is formed above the lower electrode 30.

The following will describe the operation of the micro mirror 21 in reference to Figs. 6(a)-6(c).

As shown in Fig. 6(a), in a case where the element drive control section causes the micro mirror 21 to be in the off-state, the reflecting surface 28 of the micro mirror 21 is flat. In other words, there is no phase difference between the deforming section 22 and its surroundings. In the present embodiment, incident light (its traveling direction is indicated by a heavy-solid-line arrow) emitted from the light source 10 vertically hits the reflecting surface 28. On this account, when the micro mirror 21 is in the off-state, almost all of the incident light vertically hitting the reflecting surface 28 is reflected in the direction perpendicular to the reflecting surface 28. The reflected light vertically reflected on the reflecting surface 28 is termed regular-reflected light (indicated by a dotted-line arrow in the figure).

On the other hand, in a case where the element drive control section causes the micro mirror 21 to be in the on-state, as shown in Fig. 6(b), the lower electrode 30 generates an electrostatic force in the space between the upper and lower electrodes 27 and 30. This electrostatic force causes the upper insulating layer 31 to stick to the lower electrode 30. As a result, the deforming section 22 in the reflecting surface 28 deforms so as to be dented in comparison with its surroundings. Because of this deformation, a phase difference between the deforming section 22 and its surroundings is generated.

On account of the above, as indicated by a narrow-line arrow in Fig. 6(b), incident light is diffraction-reflected at the periphery of the deforming section 22. As a result, diffraction-reflected light is generated. The diffraction-reflected light travels toward the neighboring micro mirrors 21, i.e. towards the top, bottom, right, and left of Fig. 5 (although not illustrated in Fig. 5, the micro mirrors 21 also exist above and below the illustrated micro mirrors 21).

Among these types of light reflected on each micro mirror, the diffraction-reflected light is led to the substrate 5 by the reduced projection exposure optical system 50, as described below.

To what extent the deforming section 22 deforms is preferably variable. In the SLM 2 of the present embodiment, an amount of diffraction-reflected light is changed by varying the degree of deformation of the deforming section 22. To change an amount of diffraction-reflected light, the degree of deformation of the deforming section 22 is changed as shown in Figs. 6(b) and 6(c). The degree of deformation indicates to what extent the reflecting surface of the deforming section 22 deforms in the on-state, in comparison with the reflecting surface of the deforming section 22 in the off-state.

Provided that the degree of deformation is $\lambda/4$ as indicated in Fig. 6(b), there is no regular-reflected light component in reflected light, and almost all of the reflected light is made up of diffraction-reflected light components. Provided that the degree of deformation is smaller than $\lambda/4$, e.g. $\lambda/6$ as shown in Fig. 6(c), reflected light is composed of a regular-reflected light component and diffraction-reflected light components. That is, an amount of diffraction-reflected light in this case is smaller than the amount in the case of Fig. 6(b). In this manner, an amount of diffraction-reflected light is adjusted by changing the degree of deformation of the deforming section 22.

The SLM 2 of the present embodiment is arranged such that a phase difference is generated because the deforming section 22 of the micro mirror 21 is dented and hence diffraction-reflected light is generated. However, the SLM of the present invention is not necessarily arranged in this way. That is, any types of SLMs can be adopted as long as incident light emitted from a light source is divided into diffraction-reflected light and regular-reflected light. Also, any type of SLMs may be adopted on condition that the deforming section of the micro mirror of the SLM deforms so that a phase difference between the deforming section and the reflecting surface surrounding the deforming section is generated. Therefore, "deformation" may be performed such that the reflecting surface of the deforming section protrudes in comparison with the surrounding reflecting surface.

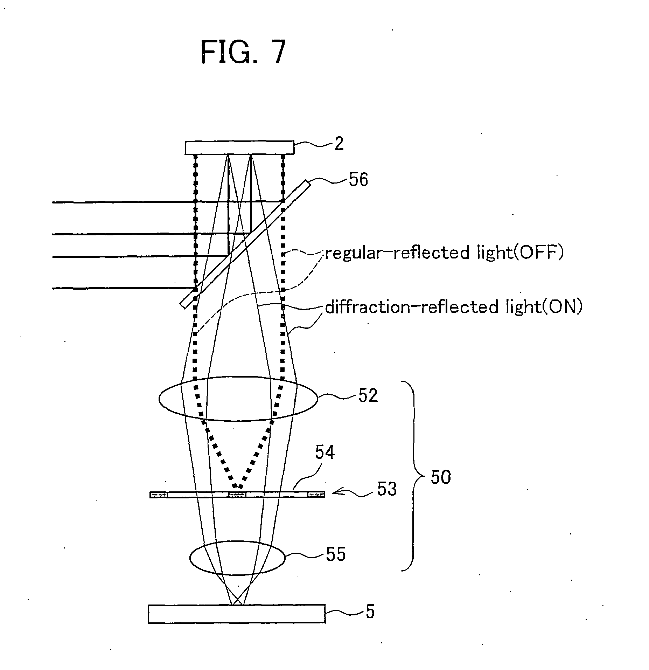

The exposure device 1 of the present embodiment causes the substrate 5 to be irradiated with the diffraction-reflected light among the diffraction-reflected light and the regular-reflected light which are divided as above. In doing so, the exposure device 1 is provided with the reduced projection exposure optical system 50 shown in Fig. 7.

Fig. 7 is a front view showing the reduced projection exposure optical system 50 and its surrounding members of the exposure device 1 of the present embodiment. In Fig. 7, the light path of incident light emitted from the light source and entering the SLM 2 is indicated by a heavy solid line. Also, among the types of light generated by dividing and modulating the incident light by the SLM 2, regular-reflected light is indicated by a dotted line, while diffraction-reflected light is indicated by a thin solid line. The regular-reflected light and the diffraction-reflected light have been described above in reference to Figs. 6(a)-6(c).

In addition to the aforesaid members shown in Fig. 4, the exposure device 1 further includes a polarized light beam splitter 56 and a reduced optical system 50 (52, 53, 55), which are provided in this order from the SLM 2 side to the substrate 5 side. The reduced optical system 50 includes a first lens array 52, a shielding member 53 having an opening 54, and a second lens group 55, which are provided in this order from the SLM 2 side to the substrate 5 side. Although in reality the reduced projection exposure optical system 50 is made up of a lot of lenses, the system 50 is described in a simplified manner so as to have only two lens groups (first lens group 52 and second lens group 55), for the sake of convenience.

Light emitted from the light source 10 is reflected on the polarizing beam splitter 56, and enters the SLM 2. Regular-reflected light (dotted line) and diffraction-reflected light (solid lines) pass through the polarizing beam splitter 56 and enter the reduced optical system 50.

The reflected light (regular-reflected light and diffraction-reflected light) entered the reduced optical system 50 is bended by a first convex lens 52 so as to head for the focal point of the first lens group 52. Since the regular-reflected light (dotted line) is shielded by the shielding member 53, the substrate 5 is not irradiated with the regular-reflected light. On the other hand, since the diffraction-reflected light (solid lines) enters the shielding member 53 at an angle different from the regular-reflected light (dotted line), the diffraction-reflected light can pass through the opening 54. After passing through the opening 54, the second lens group 55 causes the diffraction-reflected light to irradiate the substrate 5.

[Exposure Method]

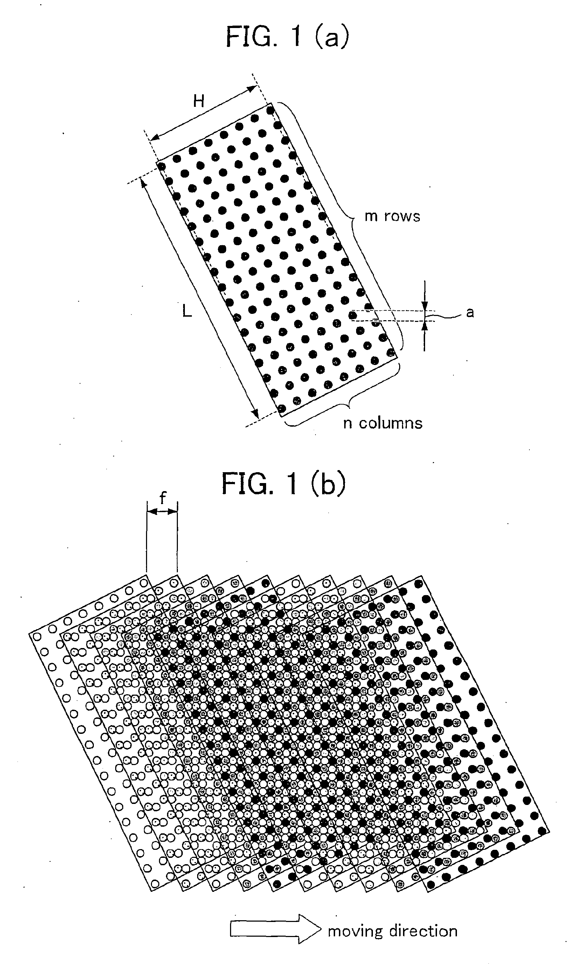

The following will describe an exposure method of the present embodiment mainly in reference to Figs. 1(a) and 1(b) to Fig. 3. It is noted that the method below can be practiced using the aforesaid exposure device of the present embodiment.

Figs. 1(a) and 1(b) are plan views showing a beam array irradiating a substrate (exposure target) in accordance with the exposure method of the present embodiment. Fig. 1(a) shows a beam array emitted in one pulse irradiation.

Fig. 1(b) shows an exposure state after the pulse irradiation is carried out more than once.

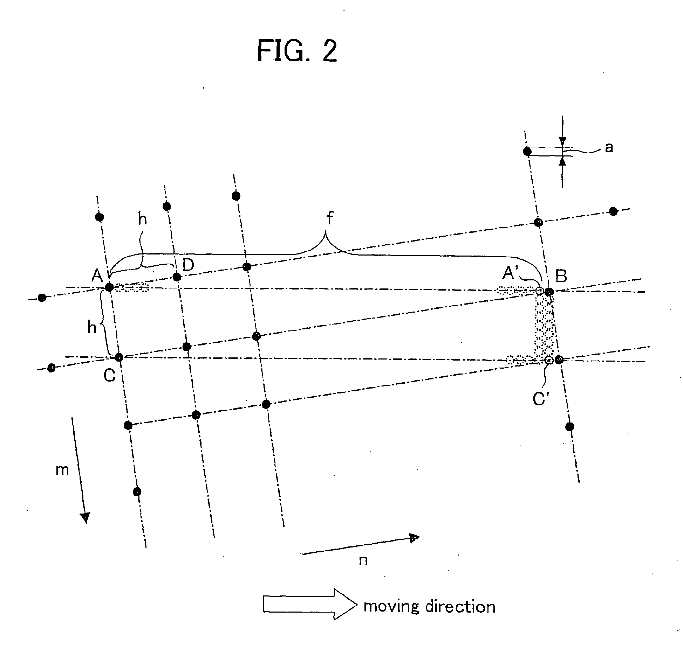

Fig. 2 is a magnified image of the beam array of the exposure method of the present embodiment.

As shown in Fig. 1(a), according to the exposure method of the present embodiment, a beam array made up of two or more light beams is applied to a substrate (exposure target) in one pulse irradiation. A light irradiation step in which the pulse irradiation is carried out with respect to the substrate, is carried out while the irradiation position of the beam array moves on the substrate (irradiation position moving step).

The beam array emitted in one pulse exposure is made up of m rows and n columns of light beams. That is, in one pulse exposure, $m \times n$ light beams are emitted. In the present embodiment, n is an integer not less than 2, and m is an integer not less than 8 and satisfying $m \geq n^3$. The number of light beams may be optionally determined as long as it is not less than 2.

As shown in Fig. 1(a), the length of the beam array along the rows is H, while the length of the beam array along the columns is L. The diameter of each light beam (i.e. beam diameter) is a.

In the present embodiment, in the irradiation position moving step, the stage 6 is moved in the X direction in Fig. 4 so that the beam array is moved in the direction (moving direction) pointed by an arrow shown in Fig. 1(b). In the specification, an interval between the start of a pulse irradiation (s-th pulse irradiation) and the start of the next pulse irradiation (s+1-th pulse irradiation) is termed pulse irradiation interval (pulse exposure interval), and a time between pulse irradiations is termed pulse interval time e. Also, the distance at which the irradiation position of the beam array moves between pulse irradiations, i.e. the distance, on the substrate, between (i) a position where irradiation of s-th pulsed light starts and (ii) a position where irradiation of s+1-th pulsed light starts is termed pulse interval moving distance f (see Fig. 1(b)).

As shown in Fig. 1(b), the beam array is continuously moved in parallel to the columns thereof, at a predetermined speed. The moving direction, however, is not necessarily in parallel to the columns, i.e. perpendicular to the rows. As described below, the exposure method of the present invention includes a case where the beam array (columns of the beam array) is tilted toward the moving direction. The moving direction and the tilt of the beam array will be described later.

According to the exposure method of the present embodiment, the pulse interval moving distance f is not shorter than the beam diameter *a* and shorter than the length H of the beam array along the columns thereof. The relationship among these values are represented as $\alpha \leq f < H$.

With the arrangement above, the exposure method of the present embodiment makes it possible, as described below, to maintain a certain level of resolution even if the stage 6 is moved at a speed closer to the maximum potential of the stage 6 than the conventional continuous exposure method. Also, the interval between pulse exposures is short as compared to the conventional stamp method. The drive time of the SLM 2 is therefore shortened, and hence the SLM 2 can exercise its capability. In short, as compared to the conventional methods, the exposure method of the present embodiment can increase the speed (exposure speed) of formation of an exposure image.

Among the light beams emitted in s-th pulse irradiation, a light beam located in i-th row and j-th column on the substrate is represented as a beam (i, j). It is noted that i is a natural number not more than n, j is a natural number not more than m, and s is a natural number.

The relationship between the beam pitch h and the beam diameter *a* is preferably h>*a*. With this arrangement, an overlapping region between neighboring beams is reduced, so that the efficiency of the use of beams is improved. The beam pitch h indicates the distance between light beams in a beam array in one pulse irradiation. (The beam pitch h is indicated by A-C and A-D in Fig. 2.) Provided that a beam spot is a portion where the substrate is irradiated with each light beam, the beam pitch is represented as the distance between the centers of neighboring two beam spots (i.e. two beam spots that are the closest to each other along the rows or columns). In the beam array of the present embodiment, the beam pitch along the rows is identical with the beam pitch along the columns. This arrangement is preferable because the size of the beam array is the smallest when the beam pitch along the rows is identical with the beam pitch along the columns.

Assume that the beam pitch along the rows is different from the beam pitch along the columns. Provided that the beam pitch along the rows is hi while the beam pitch along the columns is hj, it is preferable that hi>a, hj>a, and hi≥hj, and more preferable that hi=p×hj (p is a natural number). With this arrangement, an overlapping region between neighboring beams is reduced in size, so that the efficiency of the use of beams is improved.

As described above, while the light beams are densely aligned in the conventional method, the light beams of the present embodiment are aligned at certain intervals.

The beam diameter *a* is, as shown in Fig. 2, the diameter of each light beam in the beam array. In other words, the beam diameter *a* is identical with the diameter of a beam spot. According to the exposure method of the present embodiment, the stage does not stop while pulse irradiation is carried out, and the stage is continuously moved at a constant speed. Therefore, the length of a beam spot in the moving direction is, strictly speaking, different from the length of the beam spot in the direction (sub-moving direction) perpendicular to the moving direction. That is, the length in the moving direction is longer than the length in the sub-moving direction. However, as described below, the pulse irradiation time (pulse width) in the exposure method of the present embodiment is sufficiently shorter than the stage moving speed. On this account, the difference between the lengths in the moving direction and the sub-moving direction is tolerable. In the specification, therefore, the beam diameter indicates the length of a light beam in the sub-moving direction, and the length of the beam in the moving direction is assumed to be identical with the length of the beam in the sub-moving direction, unless otherwise stated.

The length H of the beam array along the columns thereof is the distance between the center of the beam $(1, j)_s$ and the center of the beam $(n, j)_s$, and is represented as $H=h\times(n-1)$.

The length L of the beam array along the rows thereof is the distance between the center of the beam $(i, 1)_s$ and the center of the beam $(i, m)_s$, and is represented as $L=h\times(m-1)$.

The pulse interval moving distance f is equal to the distance between the center of the beam $(i, j)_s$ and the center of the beam $(i, j)_{s+1}$. The pulse interval distance f is therefore also identical with the distance between the center of the beam corresponding to a pulse irradiation and the center of the beam corresponding to the next pulse irradiation.

As described above, the pulse interval moving distance f is the distance at which the stage 6 is moved during a pulse interval time e. Therefore, the relationship among the stage moving speed v, the pulse interval time e, and the pulse interval moving distance f in the present embodiment is represented as $f=e\cdot v$. In the meanwhile, the relationship among the pulse interval moving distance f, the beam pitch hj along the columns, and the beam diameter $a$ is represented as $f=(hj/a)^2\times a=hj^2/a$.

To drive the mirrors of the SLM and switch an exposure pattern during an interval between pulse exposures and then perform the next pulse exposure, a time (SLM drive time t) required for driving the mirrors of the SLM is preferably t<e as described below. This makes it possible to switch the SLM during an interval between pulse exposures. Also, the SLM drive time t is preferably close to the pulse interval time 2 as much as possible. This makes it possible to maximally exploit the drive speed of the SLM.

According to the exposure method of the present embodiment, pulse exposure is carried out k times. It is noted that k is an integer not less than 2.

According to the exposure method of the present embodiment, the beam array is tilted toward the moving direction, in order to subject the substrate to exposure without omission. The rows of the beam array are preferably tilted at $\sin^{-1}(a/h)$, i.e. $a/h$ radian, toward the moving direction. Since an overlapping region between light beams is minimized in this arrangement, the beams are efficiently utilized. In a case where the beam array is tilted at angles different from the aforesaid optimum angle, the beams are not efficiently utilized and the exposure without omission cannot be achieved. Even in a case where the beam array is not tilted toward the moving direction, exposure without omission is achieved if the light beams are densely aligned along the rows of the beam array (i.e. if hi=a).

Based on Figs. 1(a), 1(b), and 2, the following will discuss the relationship between pulse irradiation and the movement of an irradiation position.

Provided that pulse exposure is carried out with the tilt at $\sin^{-1}(a/h)$ where h is a multiple of a, the following specifically describes the moving distance (pulse interval moving distance f) from a beam A $(i, j)_s$ in s-th pulse irradiation to a beam A' $(i, j)_{s+1}$ in s+1-th pulse irradiation. In Fig. 2, a beam B which is the closest to the beam A $(i, j)_s$ in the moving direction and is on a line in parallel to the moving direction is represented as $(i+h/a, j+1)_s$. In this case, as shown in Fig. 2, the beam pitch h in one pulse exposure corresponds to h/a beams along the rows and columns, in terms of the number of beams (beam diameter).

In the moving direction, the distance between the beams A and B corresponds to the number of beams represented by the following equation [1].

$$[1]$$

$$\sqrt{(h/a)^2 + \{(h/a)\cdot(h/a)\}^2} = h/a \times \sqrt{1 + (h/a)^2}$$

(number of beams)

Assume that the beam A $(i, j)_s$ is moved to the beam A' $(i, j)_{s+1}$ in the next (s+1-th) pulse exposure. As shown in Fig. 2, the beam A' $(i, j)_{s+1}$ is closer to the beam A than the beam B $(i+1, j+h/a)_s$ by the beam diameter $a$. On this account, the surface of the exposure target is subjected to exposure without omission and overlap.

In this case, the distance between the beams A and A', i.e. the pulse interval moving distance f is shorter than the distance between the beams A and B, by the length corresponding to one light beam. Therefore, the distance between the beams A and A' corresponds to the number of beams represented by the following equation [2].

$$[2]$$

$$f = h \diagup a \times \sqrt{1 + (h \diagup a)^2} - 1 \text{ (number of beams)} = \text{The number k of exposures}$$

required for covering the distance between the beams A and B

This number of beams is converted to the length ($\mu$m, for example) by the following equation [3].

$$[3]$$

$$\cdot f = (h \diagup a \times \sqrt{1 + (h \diagup a)^2} - 1) \times a$$

Therefore, pulse irradiation is carried out each time the stage is moved by the pulse interval moving distance f represented by the equations above, and the space between the beams A and B is covered with almost no omission, when the pulse irradiation is carried out k times. Based on this principle, spaces other than the space between the beams A and B are also covered.

The relationship among the beam interval h, beam diameter $a$, stage moving speed v, and SLM drive time t is represented as $h^2/a/v>t$.

This formula is obtained as follows. First, assume that the above-described pulse interval moving distance f is approximate to the following equation [4].

$$[4]$$

$$f = (h \diagup a \times \sqrt{1 + (h \diagup a)^2} - 1) \times a \fallingdotseq (h \diagup a)^2 \times a = h^2 \diagup a$$

In this case, since the SLM must complete the operation before the beam A reaches A', $f/a/v>t$ is obtained. Therefore, the formula $h^2/a/v>t$ is obtained.

To increase the efficiency of the use of beams, the number n of the beams of the beam array along the columns is preferably $n=(h/a)^2 \times r$ where r is the number of multiple exposure (gray scale is generated by carrying out multiple exposures at one location).

As described above, according to the conventional continuous exposure method shown in Fig. 8, an exposure pattern of the SLM is switched while light irradiation is carried out. On this account, the moving speed of the stage must be far lower than the potential maximum speed of the stage, to keep a certain level of resolution. On the other hand, since the exposure method of the present embodiment adopts pulse exposure as described above, a certain level of resolution is maintained even if the moving speed of the stage is closer to the potential thereof than the moving speed in the conventional method.

According to the stamp method shown in Fig. 9, the pulse interval moving distance is identical with the length H of the beam array along the columns thereof. In the meanwhile, according to the present embodiment, the pulse interval moving distance f is shorter than the length H of the beam array along the columns thereof. Therefore, since the pulse exposure interval in the present embodiment is shorter than that of the stamp method, the drive time of the SLM is shortened. In other words, the SLM can exercise its capability. On this account, as compared to the stamp method, the speed (exposure speed) of formation of an exposure image is improved.

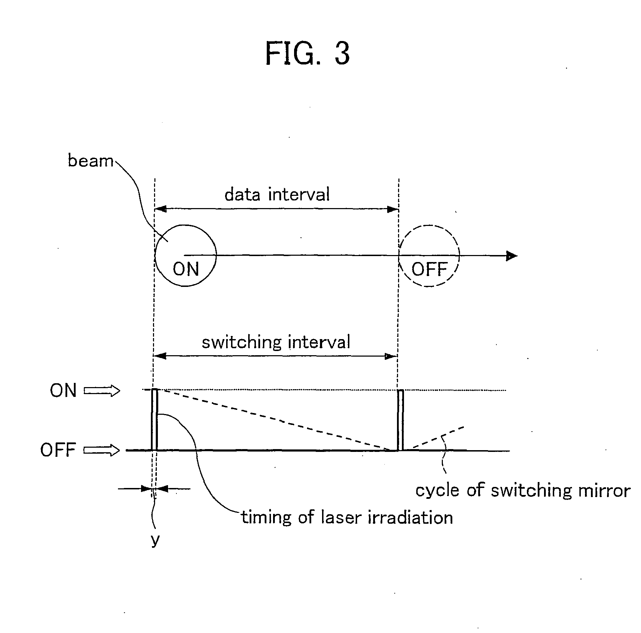

Referring to Fig. 3, pulse exposure of the present embodiment will be discussed.

Fig. 3 indicates timings to emit pulsed light in the present embodiment.

As shown in this figure, the exposure device of the present embodiment performs pulse exposure by repeatedly turning on/off laser irradiation. The SLM switches an exposure pattern in accordance with the timing of laser application, i.e. the pulse interval time e (pulse interval moving distance f). That is, the micro mirrors are turned on/off at this timing. In what manner the micro mirrors are turned on/off has already been described in reference to Figs. 6(a)-6(c).

As shown in Fig. 3, a laser is emitted from the light source 10 at data intervals of exposure data, i.e. at each pulse width y. In other words, the data interval is a pulse interval time (pulse interval moving distance). In Fig. 3, dotted lines indicate a switching cycle of the SLM, i.e. a switching cycle of micro mirrors. The SLM is in sync with the data intervals.

According to the exposure method of the present embodiment, as described above, the stage is continuously moved at a constant speed, while the pulse exposure is carried out. Therefore, as the pulse width y of applied light increases, the shape of a beam spot becomes elliptical along the moving direction. This decreases the precision of exposure. Therefore, it is preferable that the pulse width be sufficiently short in comparison with the moving speed of the stage. In other words, the pulse width is preferably arranged such that the distance at which the irradiation position moves during one pulse is not longer than the exposure precision. More specifically, the size of a beam spot is preferably controlled so as to be not longer than a third of the exposure precision.

Therefore, provided that the exposure precision is x, a tolerable change in the size of a beam spot is about x/3. The relationship among the stage moving speed v, pulse width y, and exposure precision x is represented as $y \geq (x/3)/v$.

For example, provided that the exposure precision is $0.1 \mu m$, a tolerable change in the size of a beam spot is about 30nm. Assuming that the stage moving speed is 300nm/s, the pulse width is 30nm/300nm/s=100ns.

The exposure precision is determined by the minimum resolution required by an exposure target. Optimal exposure precision typically falls within the range of about 1/5 to 1/10 of the diameter of an exposure beam spot.

Provided that, as illustrated in Example below, the pulse interval moving distance f is 32nm, a timing of laser irradiation is worked out as follows:

$$32 \mu m / 300 mm / s = 107 \mu s = 9.3 kHz$$

Examples of a laser that can perform pulse irradiation with the pulse width not more than 100ns and the frequency of about 10KHz include a solid-state laser such as an Nd-YAG laser and a gas laser such as an excimer laser. Among these lasers, a solid laser is preferable in consideration of power stability and laser power required for exposure. For example, a sufficient amount of light having an wavelength suitable for exposure can be emitted using the third harmonic wave (wavelength of 355nm) of an Nd-YAG laser.

The light source is selected in consideration of required wavelength and power. The wavelength is determined by to what extent the diameter of a beam is narrowed, i.e. by the required minimum line width. On this account, the third harmonic wave is preferable only when the beam spot diameter is not more than $0.5 \mu m$. Therefore, the wavelength may be long (about $1 \mu m$) in a case where the minimum line width is several micrometer.

With the arrangement described above, exposure with high resolution is achieved in a short period of time, without restraining the moving speed of the stage.

According to the exposure method (exposure device) of the present embodiment, a preliminary scanning area is preferably provided. This preliminary scanning area is subjected to several times of pulse irradiation at the start of exposure and several times of pulse irradiation at the end of the exposure. This area is provided because the aforesaid pulse irradiation for several times may not sufficiently cover the substrate 5. The preliminary scanning area may be provided on the substrate 5, or provided as a dummy substrate on the stage 6.

However, in a case where a sufficiently large area is subjected to exposure, the preliminary scanning area is not required because the size of an area not covered by the beams is very small as compared to the sufficiently large area.

The present invention is not limited to the description of the embodiments above, but may be altered by a skilled person within the scope of the claims. An embodiment based on a proper combination of technical means disclosed in different embodiments is encompassed in the technical scope of the present invention.

[Example]

Details of the above-described exposure device and exposure method will be given below.

The present example assumes as follows. In Fig. 5, the pitch (represented by E in the figure) of the deforming section 22 is $40 \mu m$, and the length (represented by F in the figure) of a side of the deforming section is $5 \mu m$. The reduced optical system 4 reduces the beam diameter $a$ on the substrate 5 to 1/10 of the diameter of diffraction-reflected light immediately after being generated by the SLM 2. In this case, in Fig. 2, the beam diameter a is $0.5 \mu m$, and the beam interval h is $4 \mu m$ (corresponding to the diameters of 8 spots). The number of pixels is 1563×512. In this case, the size of the beam array is $6144 \mu m \times 2048 \mu m$. The beam array is tilted at $\sin^{-1}(a/h)$, i.e. at about 1-8 radian, toward the moving direction of the beam array. This makes it possible to perform exposure with small overlapping and narrow gaps, and also to increase the speed of exposure.

In this case, as shown in Fig. 2, an interval between neighboring beams emitted in one pulse irradiation corresponds to 7 beams both along the columns (between beams A and D) and along the rows (between the beams A and C).

The distance between a beam A $(i, j)_s$ and a beam B $(i+8, j+1)_s$ which is the closest to the beam A in the moving direction is represented as the number of beams, by the following equation based on the aforesaid equation [1].

$$\sqrt{8^2 + (8 \times 8)^2} = 64.5 \text{ beams}$$

The beam A (i, j)$_s$ is moved to A' (i, j)$_{s+1}$ in the next (s+1-th) pulse exposure. As shown in Fig. 2, A' (i, j)$_{s+1}$ is closer to the beam A than the beam B (i+8, j+1)$_s$ by 0.5$\mu$m (corresponding to the beam diameter).

In this case, the distance between the beams A and A', i.e. the pulse interval moving distance f is worked out by subtracting the diameter of one beam from the distance between the beams A and B. Therefore, the distance between the beams A and A' is represented as the number of beams by the equation 64.5-1=63.5 based on the equation [2]. This value can be converted to the length ($\mu$m) in accordance with the aforesaid equations [3] and [4].

As a result, 0.5$\mu$m$\times$63.5=31.75$\mu$m (about 32$\mu$m) is obtained.

On this account, the space between the beam spots A and A' is almost entirely covered by carrying out pulse exposure 64 times (each time the stage is moved for 32$\mu$m). Based on this principle, spaces other than the aforesaid space between the spots A and A' are also covered.

According to the present embodiment, in an exposure image obtained by performing pulse exposure 64 times as above, beams are linearly aligned lengthwise and crosswise (in the moving direction and the direction perpendicular to the moving direction).

In the present embodiment, an overlapping region between neighboring beams is extremely small. When exposure is carried out 64 times, only an overlapping region corresponding to a half of one beam is formed in the last one exposure.

Therefore, the efficiency of the use of the beams is 63.5/64=99.2%. In this manner, the beams are efficiently used.

Since the pulse interval moving distance is 32$\mu$m, the pulse interval time with the assumption that the stage moving speed is at the maximum (300mm/ s) is as follows.

$$32 \times 10^{-3} / 300 = 107 \mu s$$

Therefore, the response speed required for each pixel (mirror) of the SLM, i.e. the SLM drive time t is shorter than 107$\mu$s. Since the SLM drive time is about 15$\mu$s in the present technical level, the required response speed is quite reasonable.

In this manner, the stage moving speed and the drive speed of the SLM are improved as compared to the conventional continuous exposure method and stamp method.

The embodiments and concrete examples of implementation discussed in the foregoing detailed explanation serve solely to illustrate the technical details of the present invention, which should not be narrowly interpreted within the limits of such embodiments and concrete examples, but rather may be applied in many variations within the spirit of the present invention, provided such variations do not exceed the scope of the patent claims set forth below.

**Claims**

1. An exposure method in which a beam array made up of m rows and n columns of beams is applied, by pulse irradiation, to an exposure target twice or more,
the exposure method comprising the step of (i) moving an irradiation position of the beam array at a constant speed, in a direction along the columns with respect to the exposure target,
the step (i) including the sub-step of (I) performing the pulse irradiation,
during an interval between one pulse irradiation and a directly subsequent pulse irradiation, the irradiation position moving at a distance not shorter than a diameter of each of the beams and shorter than a length of the beam array along the columns.

2. The exposure method as defined in claim 1,
wherein,
in the beam array, a pitch of the beams is longer than the diameter of each of the beams.

3. The exposure method as defined in claim 1 or 2,

wherein,

in the sub-step (I), the beam array is applied to the exposure target using a SLM, and

provided that the speed of movement of the irradiation position with respect to the exposure target is v, a drive time of the SLM is t, the pitch of the beams of the beam array is h, and the diameter of each of the beams is $a$, $h^2/a/v > t$ is satisfied.

4. The exposure method as defined in any one of claims 1-3,

wherein,

in the sub-step (I), provided that how many times multiple exposure is carried out is k, the number of the beams of the beam array along the columns is n, and the diameter of each of the beam is $a$, $n = (h/a)^2 \times k$ is satisfied.

5. The exposure method as defined in any one of claims 1-4,

wherein,

provided that the diameter of each of the beams is $a$ and the pitch of the beams is h, the rows of the beam array are tilted at $\sin^{-1}(a/h)$ toward a direction of movement of the irradiation position.

6. The exposure method as defined in any one of claims 1-5, wherein, during a pulse irradiation time, the irradiation position moves at a distance not longer than exposure precision.

7. An exposure device (1) which applies, by pulse irradiation, a beam array made up of m rows and n columns of beams to an exposure target (5) twice or more,

the exposure device (1) comprising:

irradiation position moving means (6) for moving an irradiation position of the beam array at a constant speed, in a direction along the columns with respect to the exposure target (5), and

light irradiation means (2, 10) for carrying out the pulse irradiation while the irradiation position moving means (6) is in operation,

during an interval between one pulse irradiation and a directly subsequent pulse irradiation, the irradiation position moving means (6) moving the irradiation position at a distance not shorter than a diameter of each of the beams and shorter than a length of the beam array along the columns.

8. The exposure device as defined in claim 7,

wherein,

the light irradiation means (2, 10) includes a light source (10) and a SLM (2) that forms the beam array by reflecting, using one or more mirror (21), pulsed light emitted from the light source (10), and

each of said one or more mirror (21) is individually driven so that at least one of diffraction-reflected light and regular-reflected light is generated from the pulsed light.

9. The exposure device as defined in claim 8,

wherein,

a shielding member that allows the diffraction-reflected light from the SLM to pass through while shields the regular-reflected light is provided between the SLM (2) and the exposure target (5).

10. The exposure device as defined in claim 8 or 9,

wherein,

said one or more mirror (21) has a reflecting surface (28) and generates the diffraction-reflected light by deforming a part of the reflecting surface (28).

11. The exposure device as defined in claim 10,

wherein,

said one or more mirror (21) is arranged so that to what extent said part of the reflecting surface (28) is deformed is adjustable.

12. The exposure device as defined in any one of claims 7-11,

wherein,

the light source (10) includes a solid laser.

# FIG. 1 (a)

# FIG. 1 (b)

moving direction

# FIG. 2

moving direction

# FIG. 3

# FIG. 4

Z direction

X direction

# FIG. 5

# FIG. 6 (a)

OFF

incident light and regular-reflected light

21

29    28

27
31
26
25
24

30

# FIG. 6 (b)

ON

incident light

diffraction-reflected light          diffraction-reflected light

21

$\lambda / 4$

# FIG. 6 (c)

ON

incident light and regular-reflected light

diffraction-reflected light          diffraction-reflected light

21

$\lambda / 6$

# FIG. 7

regular-reflected light(OFF)

diffraction-reflected light(ON)

# FIG. 8 (a)

SLM1 element

virtual line beams

# FIG. 8 (b)

1024
beams

157
beams

768 beams

11.3°

76.8
μ m

# FIG. 9

0.5 × 768=384um

0.5 × 1024
=512um

SLM1 element

scanning direction

# FIG. 10

# FIG. 11

# FIG. 12 (a)

# FIG. 12 (b)

**EP 1 722 273 A2**

## REFERENCES CITED IN THE DESCRIPTION

### Patent documents cited in the description

- JP 10209019 A

- JP 2004012899 A